# EUROPÄISCHE PATENTSCHRIFT

(11) **EP 0 291 445 B1**
(45) Veröffentlichungstag und Bekanntmachung des Hinweises auf die Patenterteilung: **25.08.1993**
(21) Anmeldenummer: 88730113.3
(22) Anmeldetag: 10.05.1988
(51) Int. Cl.: C23C 18/22, C23C 18/16

(54) **Verfahren zur Regenerierung von Permanganat-Ätzlösungen sowie Vorrichtung zur Durchführung des Verfahrens**
Process and apparatus for regenerating permanganate etch solutions
Procédé et appareillage de régénération des solutions de décapage à base de permanganate

(30) Priorität: 11.05.1987 DE 3716013
(43) Veröffentlichungstag der Anmeldung: 17.11.1988
(73) Patentinhaber: ATOTECH Deutschland GmbH, 10553 Berlin (DE)
(72) Erfinder: Bressel, Burkhard, Dr., D-1000 Berlin 19 (DE); Germar, Günther, D-1000 Berlin 13 (DE); Grapentin, Hans-Joachim, D-1000 Berlin 19 (DE)
(74) Vertreter: Effert, Udo, Dipl.-Ing.

(56) Entgegenhaltungen:
- EP-A- 0 204 399
- GB-A- 1 135 219

## Beschreibung

Die Erfindung betrifft ein Verfahren zum Aufrauhen und Reinigen von Kunststoffoberflächen, insbesondere Leiterplatten, mittels Permanganat-Ätzlösungen, ohne Bildung unerwünschter Reaktionsprodukte, wobei sechswertiges Mangan durch eine an sich bekannte elektrochemische Oxidation zu siebenwertigem Mangan oxidert wird.

Ätzlösungen sind in der Kunststoffgalvanisierung und insbesondere bei der Leiterplattenherstellung weit verbreitet. Sie dienen zur Reinigung der exponierten Oberflächen und zu deren Aufrauhung, um die Haftung der nachfolgend aufgebrachten Metallschichten zu gewährleisten. Insbesondere bei der Leiterplattenherstellung werden derartige oxidative Aufrauh- und Reinigunsgprozesse für die zu metallisierenden Flächen eingesetzt.

Zum einen ist die Haftung des metallischen Überzugs in den Bohrlöchern auch unter thermischen Schockbedingungen einzuhalten. Zum anderen werden diese Ätzlösungen zum Erzielen einer ausreichenden Haftung für die Vorbehandlung ebener Leiterplattenflächen verwendet.

Die für diesen Zweck eingesetzten Pemanganat-Ätzlösungen haben den Vorteil einer verhältnismäßig geringen Toxizität.

Darüberhinaus wirken Permanganat-Ätzlösungen auf die Bohrlochinnenwandungen, so daß eine wesentlich bessere mechanische Verankerung der nachfolgend abgeschiedenen Metallschichten erfolgen kann. Dadurch wird selbst unter thermischen Schockbedingungen eine sehr gute Haftung des Metallbelages auf der Innenwandung erreicht.

Das bei der Reaktion des Permanganations mit der Kunststoffoberfläche gebildete Manganation in der Oxidationsstufe VI kann zwar durch geeignete chemische Oxidationsmittel zum Permanganat regeneriert werden, um eine ausreichende Lebensdauer der Ätzlösung zu erreichen (EP-A1-0 204 399), jedoch muß hier ständig teures Oxidationsmittel hinzugefügt werden.

Außerdem kommt es jedoch zur Bildung von unerwünschten Reaktionsprodukten, welche die Lebensdauer der Ätzlösung stark verkürzen.

Ein weiterer Nachteil besteht darin, daß der Gehalt an gebildetem Manganat ständig analytisch kontrolliert werden muß, um die erforderliche Zugabe des Oxidationsmittels zu steuern.

Die Erfindung ist die Zurverfügungstellung eines Verfahrens, welche eine nahezu überwachungsfreie Regenerierung von störenden Permanganat-Ätzlösungen ohne die Bildung von Reaktionsprodukten ermöglicht.

Diese Aufgabe wird erfindungsgemäß durch das Verfahren gemäß dem kennzeichnenden Teil der Patentansprüche gelöst.

Eine vorteilhafte Weiterbildung ist in dem Unteranspruch gekennzeichnet.

Das erfindungsgemäße Verfahren ermöglicht in bisher nicht erreichter Weise eine Regenerierung von zum Reinigen und Aufrauhen von Kunststoffoberflächen verwendeten Permanganat-Ätzlösungen durch Anwendung einer elektrochemischen anodischen Oxidation (GB-A-1 135 219).

Der besondere Vorteil des erfindungsgemäßen Verfahrens besteht darin, daß dabei eine praktisch unbegrenzte Lebensdauer der Permanganat-Ätzlösung erzielt wird. Daraus ergibt sich zum einen eine einfachere Badführung, indem auf die analytische Überwachung des Mn(VI)-Gehaltes verzichtet werden kann. Zum anderen entfällt auch weitgehend eine eventuell erforderliche Entsorgung.

Ein wesentlicher weiterer Vorteil besteht darin, daß die bei der Ätzung des Kunststoffes entstehenden Reaktionsprodukte sehr viel effektiver und schneller zu CO₂ und H₂0 oxidiert werden können, als mit herkömmlichen Oxidationsmitteln. Dadurch ist eine störungsfreie Ätzbadführung gewährleistet.

Als Permanganat-Ätzlösung finden übliche wässrige alkalische Kaliumpermanganat-Lösungen Verwendung.

Die Durchführung des erfindungsgemäßen Verfahrens bei einer Gleichspannung von 0,5 bis 25 Volt und einer Stromdichte von 0,1 bis 20 A/dm², wobei Abweichungen möglich sind und es wird eine elektrochemische Vorrichtung eingesetzt, welche zwei durch ein Diaphragma voneinander getrennte Elektrolyträume enthält.

Der eine Elektolytraum stellt den Anolytraum für die zu regenerierenden Ätzlösung dar, der andere Raum ist als sogennanter Katholytraum für eine alkalische Lösung vorgesehen.

Als alkalische Lösung wird vorzugsweise eine wässrige Alkalihydroxid-Lösung, beispielweise mit 60 g Natriumhydroxid/Liter, verwendet. Jeder Raum ist mit einer Elektrode ausgestattet, die für den Anolytraum vorteilhafterweise aus platiniertem Titan, Nickel oder Edelstahl und für den Katholytraum aus Edelstahl bestehen sollte.

Die verwendete Vorrichtung bringt optimale Ergebnisse - eine ausreichende Regenerierung läßt sich jedoch auch dann erreichen, wenn eine Vorrichtung mit nur einem Elektrolytraum verwendet wird, an den beide Elektroden eintauchen.

Das erfindugsgemäße Verfahren kann für die Regenerierung aller Permanganat-Ätzlösungen eingesetzt werden, die zum Einsatz für die Reinigung und Aufrauhung von Kunststoffoberflächen für die nachfolgende Metallisierung vorgesehen sind. Ein herausragendes Einsatzgebiet stellt jedoch die Leiterplattenfertigung für die elektrochemische Industrie dar, wo Höchstanforderungen gestellt werden.

Das folgende Beispiel dient zur Erläuterung der Erfindung.

### BEISPIEL 1

Eine verbrauchte Kaliumpermanganat-Atzlösung folgender Zusammensetzung:
31,5 g/l KMnO₄,
27,0 g/l K₂MnO₄,
wird in einer elektrochemischen Zelle, die zwei getrennte Elektrolyträume, Anolyt und Katholyt, enthält, mit einer anodischen Stromdichte von 2 A/dm² bei einer anodischen Stromdichte von 2 A/dm² bei einer Zellspannung von ca. 3,5 Volt und einer Temperatur von 65° C elektrolysiert.

Die beiden Elektrolyträume sind durch ein Tondiaphragma voneinander getrennt. Im Kathodenraum befindet sich eine Lösung mit 60 g/l NaOH. Die Anode besteht aus Titanstreckmetall, die Kathode aus Edelstahl.

Nach 6 Stunden wird ein KMnO₄-Gehalt von 50,6 g/l und ein K₂MnO₄-Gehalt von 3,0 g/l analysiert.

### BEISPIEL 2

In einer Kaliumpermanganat-Ätzlösung folgender Zusammensetzung:
60 g/l KMnO₄,
15 g/l K₂MnO₄
und 30 g/l NaOH
werden innerhalb einer Stunde ca. 30 m² doppelseitig mit Kupferkaschierung versehene Leiterplattenzuschnitte, die zur nachfolgenden Durchkontaktierung auch gebohrt sind, behandelt. Die Temperatur der Ätzlösung beträgt 75° C.

In einem separaten Behälter sind in mit einem Tondiaphragma voneinander getrennten Elektrolyträumen zwei Elektroden angeordnet, deren eine aus Nickel und die andere aus Kupfer bestehen. In dem die Kupferelektrode enthaltenden Elektrolytraum befindet sich eine NaOH-Lösung (60 g/l). Durch den anderen Elektrolytraum wird fortwährend die im Arbeitsbehälter befindliche Kaliumpermanganat-Ätzlösung hindurchgepumpt und anschließend zum Arbeitsbehälter wieder zurückgeführt. Die Temperatur im Elektrolysierbehälter beträgt 75° C. Die anodische Stromdichte wird auf ca. 4A/dm² eingestellt. Es regelt sich dann eine Spannung von 5-8 Volt zwischen Anode und Kathode ein.

Die anfangs eingestellten Konzentrationen für KMnO₄ und K₂MnO₄ werden nach Ablauf des Versuchszeitraumes von einer Stunde analysiert. Es werden folgende Konzentrationen gefunden:
61 g/l KMnO₄
und 13 g/l K₂MnO₄.

## Patentansprüche

1. Verfahren zum Aufrauhen und Reinigen von Kunststoffoberflächen, insbesondere Leiterplatten, mittels Permanganat-Ätzlösungen ohne Bildung störender Reaktionsprodukte, dadurch gekennzeichnet, daß sechswertiges Mangan durch elektrochemische Oxidation zu siebenwertigem Mangan oxidiert wird, und daß die Oxidation in einer elektrochemischen Vorrichtung durch anodische Oxidation erfolgt.

2. Verfahren gemäß Anspruch 1, dadurch gekennzeichnet, daß die Oxidation bei einer Gleichspannung von 0,5 bis 25 Volt und einer Stromdichte von 0,1 bis 20 A/dm² durchgeführt wird.

## Claims

1. Method for roughening and cleaning plastic surfaces, in particular those of printed circuit boards, using permanganate etching solutions and avoiding undesired reaction products, characterized in that hexavalent manganese is oxidized into heptavalent manganese by electrochemical oxidation and in that oxidation is performed by anodic oxidation in an electrochemical device.

2. Method in accordance with Claim 1, characterized in that the oxidation process is carried out with 0.5 to 25 volts DC and a current density of 0.1 to 20 A/dm².

## Revendications

1. Procédé permettant de lainer et nettoyer des surfaces de matières plastiques, en particulier les surfaces de plaquettes à circuits imprimées, à l'aide de solutions de décapage à base de permanganate sans formation de produits reactionnels nuisibles, caractérisé en ce que du manganèse hexavalent est transformé en manganèse heptavalent par oxidation électrochimique, et en ce que cette oxidation est effectuée par anodisation dans un dispositif électrochimique.

2. Procédé suivant la revendication 1, caractérisé en ce que l'oxidation est effectuée à une tension directe comprise entre 0,5 et 25 volt et une densité de courant entre 0,1 et 20 A/dm².
